(19) Europäisches Patentamt / European Patent Office / Office européen des brevets

(11) **EP 4 399 449 B1**

(12) **EUROPEAN PATENT SPECIFICATION**

(45) Date of publication and mention
of the grant of the patent:
**11.03.2026 Bulletin 2026/11**

(21) Application number: **21777438.9**

(22) Date of filing: **09.09.2021**

(51) International Patent Classification (IPC):
$F23C\ 10/04^{(2006.01)}$    $F23C\ 10/28^{(2006.01)}$
$F23N\ 5/02^{(2006.01)}$    $F23N\ 5/24^{(2006.01)}$

(52) Cooperative Patent Classification (CPC):
**F23C 10/04; F23C 10/28; F23N 5/022; F23N 5/242;**
F23N 2223/06; F23N 2223/40; F23N 2223/48;
F23N 2225/08

(86) International application number:
**PCT/EP2021/074840**

(87) International publication number:
**WO 2023/036427 (16.03.2023 Gazette 2023/11)**

(54) **METHOD FOR ESTIMATING RISK OF FLUIDIZED BED COMBUSTION BOILER BED SINTERING AND COMBUSTION BOILER**

VERFAHREN ZUR SCHÄTZUNG DES RISIKOS DES SINTERNS EINES KESSELBETTS EINER WIRBELSCHICHTVERBRENNUNG UND KESSEL

PROCÉDÉ D'ESTIMATION DU RISQUE DE FRITTAGE DE LIT DE CHAUDIÈRE À COMBUSTION À LIT FLUIDISÉ AINSI QUE CHAUDIÈRE À COMBUSTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**17.07.2024 Bulletin 2024/29**

(60) Divisional application:
**26154767.3 / 4 707 675**

(73) Proprietor: **Sumitomo SHI FW Energia Oy
02130 Espoo (FI)**

(72) Inventors:
• **LIUKKONEN, Mika
70870 Hiltulanlahti (FI)**
• **MIETTINEN, Jouni
78500 Varkaus (FI)**
• **KETTUNEN, Ari
79100 Leppävirta (FI)**

(74) Representative: **Genip Oy
Heikinkatu 7
48100 Kotka (FI)**

(56) References cited:
WO-A2-2009/105013     CN-A- 112 696 667
CN-B- 104 214 772     CN-B- 110 887 038
EA-B1- 031 280

## Description

### Field of the invention

The invention relates to control of fluidized bed combustion boilers, such as circulating fluidized bed (CFB) boilers or bubbling fluidized bed (BFB) boilers.

### Technical background

Combustion boilers, such as grate boilers and fluidized bed boilers are commonly utilized to generate steam which can be used for variety of purposes, such as for producing electricity and heating.

In a fluidized bed boiler, fuel and solid particulate bed material is introduced into a furnace and by introducing fluidizing gas from a bottom portion of the furnace to fluidize the bed material and fuel. Burning of fuel takes place in the furnace. In BFB combustion, fluidization gas is passed through the bed such that it forms bubbles in the bed. The fluidized bed can in a BFB be rather conveniently controlled by controlling the fluidization gas feed and fuel feed.

In CFB combustion, fluidization gas is passed through the bed material. Most bed particles will be entrained in the fluidization gas and they will be carried by the fluidization gas. The particles are separated from the fluidization gas and circulated returning them into the furnace.

In all boilers, regardless of the combustion technology, the combustion conditions, such as, the mixing of oxygen and fuel, may not be ideal.

### Objective of the invention

It is the objective of the invention to improve the estimation of the risk of fluidized bed combustion boiler bed sintering. This objective can be met with the method according to independent claim 1, the two-part-form of which is based on the document WO 2009/105013 A2.

It is a further objective of the invention to provide a combustion boiler system configured to carry out the method according to the invention.

Further objectives not related to the invention are to improve bed control in a fluidized bed combustion boiler system.

The dependent claims describe advantageous aspects of the inventive method.

### Advantages of the invention

Not according to the invention, a first-mentioned method for determining a local temperature anomaly in a fluidized bed of a combustion boiler system that comprises a furnace having a boiler grid that is equipped with at least three temperature sensors that together define a measurement grid where each temperature sensor represents a measurement point comprises the steps of:

- measuring bed temperatures at the measurement points;
- computing bed temperatures for the measurement points using at least one numerical bed temperature model, to obtain computed bed temperatures under normal operation conditions of the combustion boiler system;
- the measured bed temperatures are compared with the computed bed temperatures for at least some of the measurement points, and if an anomaly threshold is exceeded, determining that local temperature anomaly is present.

With the method, the at least three temperature sensors that are used to monitor the bed temperature, together with the numerical bed temperature model, increase the accuracy of the fluidized bed temperature measurement in such an extent that now it has become possible to detect local bed temperature anomalies.

In particular, and especially if, the bed temperatures are measured at the boiler grid, the local anomalies can be, without be willing to be bound by a theory, seen related to beginning of a sintering condition in a fluidized bed. The present inventors have observed that local temperature anomalies act as precursors for the fluidized bed beginning to sinter. Thus, by monitoring the measured bed temperatures with the computed bed temperatures, a beginning bed sintering can be detected and measures to heal the bed or at least to avoid the sintering becoming worse can be taken in good time. This may help to avoid combustion boiler system shutdowns because of bed sintering, and also the costly reparations. Advantageously, bed temperature anomalies give information on bed quality, preferably, information whether sintering is taking place in the bed. Or in other words, it will be possible to receive information about bed-related problem that may have a tendency of leading to a shutdown if no remedial action is taken. Therefore, the availability of the boiler may be improved and/or operational costs may be reduced. The method is preferably carried out automatically either in local boiler control system or remotely, preferably in a process intelligence system.

The computed bed temperatures for the measurement points may be obtained in the following way:

- a numerical model between boiler operation data, namely at least primary air flow, fuel moisture, main steam flow, flue gas oxygen and bed pressure and the measured bed temperatures at each measurement point, is prepared and calibrated;

- current operation data of the boiler, including the measured bed temperature at each measurement point and at least primary air flow, fuel moisture, main steam flow, flue gas oxygen and bed pressure, is monitored;

- for at least one measurement point, the numerical model is used to compute a computed temperature, using current operation data and measured bed temperatures of at least two other measurement points;

- comparing the computed temperature and the measured bed temperature against an anomaly criterion and determining that local temperature anomaly is present if the anomaly criterion is fulfilled.

The calibration may be performed in a delayed manner using historical data that is preferably at least M days old, where M is at least 3, preferably M is at least 7, more preferably M is at least 14. In this way, it may better be ensured that a bed quality problem that is just developing will not contaminate the calibration.

The computed bed temperature model may be obtained from equation

$$y = b_0 + b_1 \times x_1 + b_2 \times x_2 + b_3 \times x_3 + b_4 \times x_4 + b_5 \times x_5 + b_6 \times x_6,$$

where:

$b_0 \ldots b_6$ are the model coefficients obtained from a linear regression model
$x_1$ = Total air flow, calculated as a sum of primary ($x_{1prim}$) and secondary air flow ($x_{1sec}$)
$x_2$ = fuel moisture
$x_3$ = Average of bed temperature measurements ($x_{3a}$, $x_{3b}$) that are adjacent to the output bed temperature measurement (y) $x_4$ = Flue gas oxygen content
$x_5$ = Mean of bed pressure
$x_6$ = Mean of recirculation gas flow.

Fuel moisture may be calculated or measured.

The computed bed temperature model may be obtained from equation

$$y = b_0 + b_1 \times x_1 + b_2 \times x_2 + b_3 \times x_3 + b_4 \times x_4 + b_5 \times x_5 + b_6 \times x_6,$$

where:

$b_0 \ldots b_6$ are the model coefficients obtained from a linear regression model
$x_1$ = Total air flow, calculated as a sum of primary ($x_{1prim}$) and secondary air flow ($x_{1sec}$)
$x_2$ = flue gas H2O content
$x_3$ = Average of bed temperature measurements ($x_{3a}$, $x_{3b}$) that are adjacent to the output bed temperature measurement (y)
$x_4$ = Flue gas oxygen content
$x_5$ = Mean of bed pressure
$x_6$ = Mean of recirculation gas flow.

The computed bed temperatures may be obtained using artificial intelligence tools. According to an embodiment of the invention, computed bed temperatures may be obtained using neural networks.

Preferably, the calibration is not performed (i.e. the calibration is omitted) for a predefined time upon detecting a local temperature anomaly. In addition to, or alternatively, boiler shut down situations, abnormal operation and/or abnormal bed conditions are preferably filtered out or omitted from calibration data. This approach may help to avoid a possible bed quality problem to contaminate the calibration. This approach can be fine-tuned such that the calibration is not performed for a predefined time upon detecting a local temperature anomaly that fulfills a given threshold. Then only severe enough conditions producing a sufficiently large anomaly signal can be chosen to be lead to the skipping of calibration for a predefined time period.

Not according to the invention, a second-mentioned method for calibrating a numerical model of a fluidized bed of a combustion boiler system comprises a furnace having a boiler grid that is equipped with at least three temperature sensors that together define a measurement grid where each temperature sensor represents a measurement point, and wherein the combustion boiler system has been configured to produce measured bed temperatures at each of the measurement points

That is preferably used in the context of the first-mentioned method not according to the invention:

- current operation data of the boiler, including the measured bed temperature at each measurement point and at least primary air flow, fuel moisture, main steam flow, flue gas oxygen and bed pressure, is monitored and collected to historical data;
- a numerical model between boiler operation data, namely at least primary air flow, fuel moisture, main steam flow, flue gas oxygen and bed pressure and the measured bed temperatures at each measurement point is fitted using at least one numerical fitting method, preferably a numerical regression method, advantageously least squares fitting.

In this manner, a calibrated numerical model can be generated that will produce suitably precise results in different operation conditions of the combustion boiler system.

The calibration may be repeated at predefined intervals, such as, periodically. This helps to keep the calibration actual, reflecting the possible wear and tear of the combustion boiler system, but also to changes in fuel quality, the environmental conditions (temperature, ambient humidity, ambient pressure changes) which may lead to operation parameters changing over time.

The calibration may be prevented upon detecting a local temperature anomaly. In this manner it may better be ensured that a bed quality problem that is just developing will not contaminate the calibration.

With regard to the objective of the invention, the method for estimating sintering risk in boiler bed of a fluidized bed combustion boiler system which comprises a furnace having a boiler grid that is equipped with at least three temperature sensors that together define a measurement grid where each temperature sensor represents a measurement point, comprises the steps of:

- current operation data of the boiler, namely the measured bed temperature, is measured at each measurement point;
- based on the current operation data of the boiler,

    i) an average of the measured bed temperatures is computed;

    ii) standard deviation of measured bed temperature is computed;

    iii) a difference between measured bed maximum temperature and measured bed minimum temperature is computed;

    iv) spread is computed for the measured bed temperatures;

- using the computation results from i), ii), iii) and iv), a bed sintering index is prepared.

One possibility for the definition of sintering index that preferably is used may be:
when

    i) an average of the measured bed temperatures is computed;

    ii) standard deviation of measured bed temperature is computed;

    iii) a difference between measured bed maximum temperature and measured bed minimum temperature is computed;

    iv) spread $x_{spread, i} = x_i - \bar{x}_{\sim xi}$, is computed for the measured bed temperatures;

those are compared with corresponding predefined limits so as to get sintering risk indexes for average, deviation, difference and spread.

Similarly,

when

v) computed bed temperatures $T_{Ci}$; I = 1, ..., n for same measurement points are computed, and residuals between the measured bed temperatures $T_{Mi}$; i = 1, ..., n and the computed bed temperatures are computed.

it is compared with corresponding predefined limit so as to get sintering risk index for bed temperature residuals.

The final risk index may then be the maximum of above risk indexes, for example.

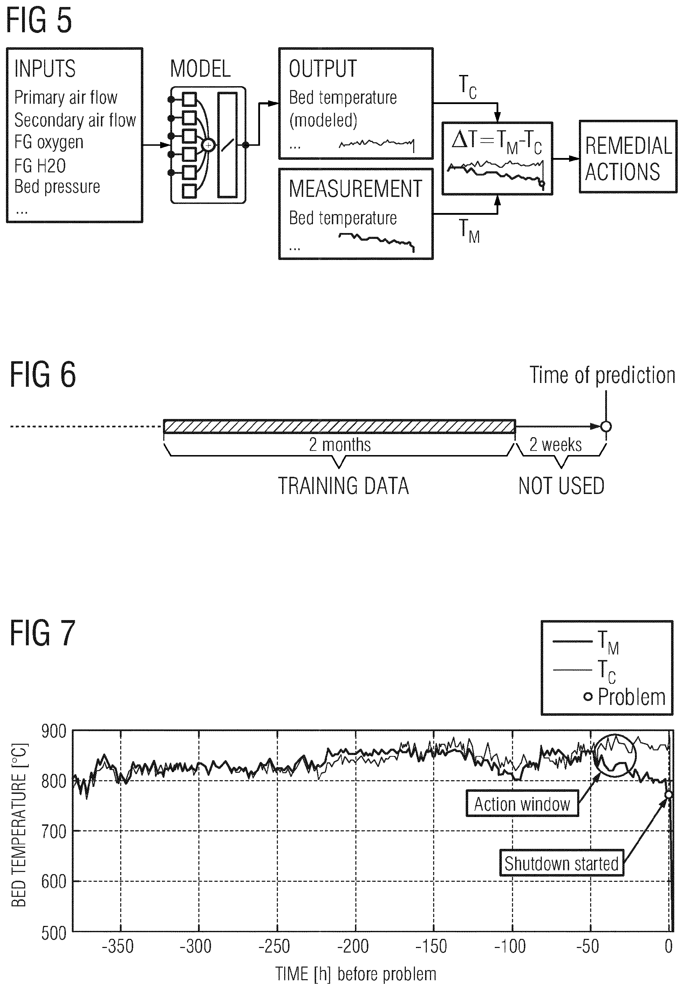

The present inventors have observed that in this manner, the resulting bed sintering index provides an indication of a fluidized bed condition that could lead to shutting down the boiler unless treated, early enough to take corrective actions such that the need to shut down the boiler may be avoided. This aspect will be discussed in more detail with reference to FIG 7.

Preferably, in the method, further,

v) computed bed temperatures for same measurement points are computed, and residuals between the measured bed temperatures and the computed bed temperatures are computed; and wherein results from step v) are also used in the preparing of the bed sintering index.

In this manner, the predictive accuracy of bed sintering index can be still improved.

In the method according to the objective of the invention, the computed bed temperatures may be obtained by using the first-mentioned method.

Not according to the invention, in a third-mentioned method of controlling a fluidized bed boiler system:

local bed temperature anomalies and/or a bed sintering index is/are monitored;

upon detecting a local bed temperature anomaly and/or bed sintering index exceeding a predefined criteria, automatically adjusting combustion boiler system operation and/or indicating the boiler operator that a local bed temperature anomaly and/or a bed sintering condition is detected.

In this manner, the combustion boiler system can either be controlled automatically to prevent bed sintering, or the operator will be able to take action upon being informed of the local bed temperature anomaly and/or bed sintering condition, to prevent bed sintering.

The automatic adjustment of boiler operation may include at least one of the following: a) increasing or decreasing combustion air feed, b) increasing or decreasing fuel feed, c) increasing or decreasing bed material feed and/or bed material removal, d) adjusting recirculation gas flow, e) restricting the boiler load temporarily.

Preferably, combustion air comprises primary and secondary air. Recirculation gas flow preferably includes or consists of the recirculated part of flue gases.

The automatic adjustment or so-called remedial actions include at least one of the following:

- changing fuel mix
- triggering air pulse(s) through primary air nozzles that are at the boiler grid
- introducing feed additives such as clay which may be hydrous clay (kaolin, for example), or increasing the amount of such feed additives.

Measured bed temperature may start to decrease in the early phase of of sintering. Hence, an abnormal bed condition may be determined when in the course of bed monitoring it is determined that the bed temperature is lower than modelled bed temperature, such that the anomaly threshold is exceeded.

The local bed temperature anomalies may be monitored using the method according to the first-mentioned method.

The bed sintering index is monitored using the method according to the objective of the invention.

Preferably, in the method, the local bed temperature anomalies and/or the monitoring sintering index is/are monitored is a numerical model. A delayed calibration of the numerical model may be used to reduce or avoid the effect of recent bed conditions in the calibration data.

Advantageously, the delayed calibration is performed using the method according to the second-mentioned method.

The combustion boiler system is configured to carry out the method according to the objective of the invention.

**List of drawings**

In the following, the methods and the combustion boiler are explained in more detail with reference to the exemplary embodiments shown in the appended drawings in FIG 1 to 8B, of which:

FIG 1                illustrates a CFB boiler system;

FIG 2            illustrates a BFB boiler system;

FIG 3            illustrates boiler grid and measurement arrangement therein;

FIG 4            illustrates the sintering risk calculation method;

FIG 5            illustrates the residual calculation method;

FIG 6            illustrates the method of delayed calibration;

FIG 7            illustrates the results obtained with the residual calculation method;

FIG 8A and 8B   illustrate the results of risk calculation method utilized on real operation data of a combustion boiler system, for the situation of FIG 7.

Same reference numerals refer to same technical features in all FIG.

**Detailed description**

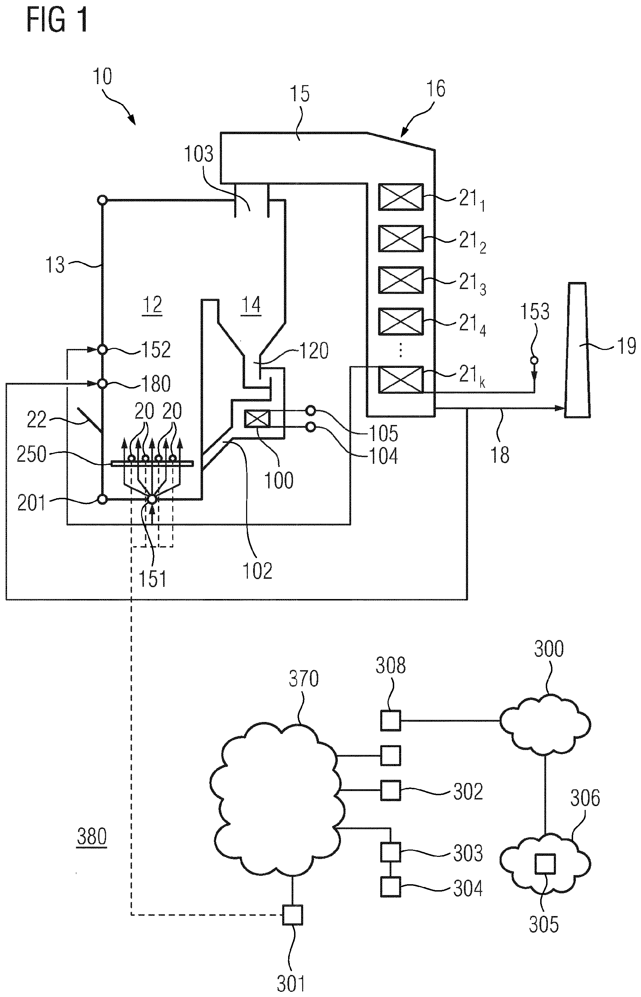

FIG 1 shows a combustion boiler system 10 that is a CFB boiler and comprises a furnace 12 that has tube walls 13 (typically comprising a front wall 132, rear wall 134, side walls 131, 133) connected to water-steam circuit of the combustion boiler system 10. Water may be fed from water tank to economizer and from the economizer via a steam drum to evaporative heat transfer surfaces such as the tube walls 13 and then guided via the steam drum to superheaters and then to a turbine. Flue gas channel may be provided with economizer and/or superheater/s and/or reheaters.

Fluidization gas (such as, air and/or oxygen-containing gas) is fed from fluidization gas supply 153 to below the grid 250 via primary fluidization gas feed 151, usually such that the primary fluidization air enters the furnace through nozzles at the grid 250 (to fluidize the fuel and bed material), and secondary fluidization gas feed 152 (to feed oxygen containing gas such as air to control combustion). The effect is that the bed materials will be fluidized and also oxygen-containing gas required for the combustion is provided into the furnace 12. Further, fuel is fed into the furnace 12 via the fuel feed 22.

The combustion can be adjusted by controlling the fuel feed 22 (such as, by reducing or increasing fuel feed 22), and by controlling the fluidization gas feed (such as, by reducing or increasing amount of oxygen or oxygen-containing gas, preferably combustion air, supply into the furnace 12). Fuel can be fed together with additives, in particular with such additives that act as alkali sorbents, such as CaCO3 and/or clay for example. In addition or alternatively, NOx reduction agents, such as ammonium or urea can be fed into the combustion zone of the furnace 12, or above the combustion zone of the furnace 12.

Bed material introduced into the furnace may comprise sand, limestone, and/or clay, that in particular may comprise kaolin. One effect of the bed and, generally, of the combustion, is that in the water-steam circuit, water and steam is heated in the tube walls 13 and water is converted to steam.

Bottom ash may fall to the bottom of the furnace 12 and be removed via an ash chute (omitted from FIG 1 for the sake of clarity) whereas part of the ash, so-called fly ash is carried with flue gas.

Combustion products, such as flue gas, unburnt fuel and bed material proceed from the furnace 12 to a particle separator 14 that may comprise a vortex finder 103. The particle separator 14 separates flue gases from solids. Especially in larger combustion boilers 10, there may be more than one (two, three, ...) separators 14 preferably arranged in parallel to each other.

Solids separated by the separator 14 pass through a loop seal 120 that preferably is located at the bottom of the separator 14. Then the solids pass to fluidized bed heat exchanger (FBHE) 100 that is also a heat transfer surface (such as, but not limited, comprising tubes and/or heat transfer panels) so that the FBHE 100 collects heat from the solids to further heat the steam in the water-steam circuit.

The FBHE 100 may be fluidized and comprise heat transfer tubes or other kinds of heat transfer surfaces and be arranged as a reheater or as a superheater. From the FBHE outlet 105, steam is passed into a high-pressure turbine (if the FBHE 100 is superheater) or medium-pressure turbine (if the FBHE 100 is a reheater). The FBHE inlet 104 preferably comes from the economizer (when the FBHE 100 is superheater) or from the high-pressure turbine (when the FBHE 100 is reheater).

The solids may exit the FBHE 100 via return channel 102 into furnace 12. Especially in larger combustion boilers 10, there may be more than one (two, three, ...) loop seals 120 and FBHE 100, and return channel 102, preferably arranged in parallel to each other, such that for each separator 14, there will be respective loop seal 120, FBHE 100 and return channel 102. In practice, some of the FBHE 100 may be arranged as superheaters while some others may be arranged as reheaters.

The flue gases are passed from the separator 14 to crossover duct 15 and from there further to back pass 16 (that preferably may be a vertical pass) and from there via flue gas duct 18 to stack 19.

The back pass 16 comprises a number of heat transfer surfaces 21i (where i = 1, 2, 3, ..., k, where k is the number of heat transfer surfaces). In FIG 1, of the heat transfer surfaces, heat transfer surfaces $21_1$, $21_2$, $21_3$, $21_4$, ..., $21_k$ are illustrated. Heat transfer surface $21_k$ depicts air preheater. Other heat transfer surfaces $21_1$ to $21_{k-1}$ may include economizer, superheaters and reheaters. The actual number of different heat transfer surfaces in each of these components, for example, may be selected for each combustion boiler differently according to actual needs. And there may be further components as well, comprising a heat transfer surface 21.

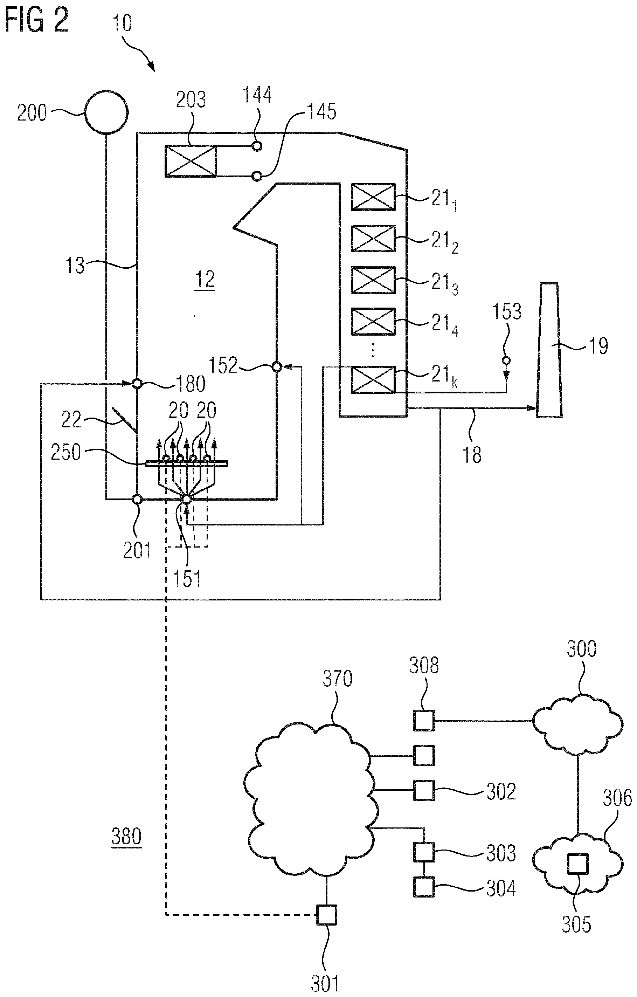

A combustion boiler system 10 is equipped with a plurality of sensors and computer units. Actually, one middle-size (100 - 150 MWth) combustion boiler system 10 may produce 100 million measurement results / day, which needs 25 GB of storage space. FIG 1 and 2 illustrate some of the sensors and computer units. Examples of sensors are temperature sensor measuring the output steam temperature at the outlet 105 of the FBHE 100, pressure sensor measuring pressure at the FBHE 100 chamber, temperature sensor measuring the flue gas exit temperature at the separator 14, the temperature sensor measuring the temperature in the loop seal 120, and the pressure sensor measuring the pressure in the loop seal.

Process data may be collected from the sensors by distributed control system (DCS) 301. The data collection may most conveniently be arranged over a field bus 378, for example. DCS 301 may have a display/monitor 302 for displaying operational status information to the operator. An EDGE server 303 may process measurement data from the obtained from sensors, such as, filter and smooth it. There may be a local storage 304 for storing data.

The DCS 301, display/monitor 302, EDGE server 303, local storage 304 may be in combustion boiler network 370 (local storage 304 preferably directly connected to the EDGE server 303). The combustion boiler network 370 is preferably separate from the field bus 380 that is used to communicate measurement results from the sensors to the DCS 301 and/or the EDGE server 303. Between the DCS 301 and EDGE server 303 there may be an open platform communications server to make the systems better interoperable.

Combustion boiler network 370 may be in connection with the internet 300, preferably via a gateway 308. In this situation, measurement results may be transferred from the combustion boiler network 370 to a cloud service, such as to process intelligence system 305 located in a computation cloud 306. The applicant currently operates a cloud service running an analysis platform. The cloud service may be operated on a virtualized server environment, such as on Microsoft® Azure® which is a virtualized, easily scalable environment for distributed computing and cloud storage for data. Other cloud computing services may be suitable for running the analysis platform too. Further, instead of a cloud computing service, or in addition thereto, a local or remote server can be used for running the analysis platform.

FIG 2 illustrates a combustion boiler system 10 that is a BFB boiler. BFB boiler differs from CFB boiler in that the fluidized bed is not a circulating bed but a bubbling bed. Thus, there is no need for the separator 14, loop seal 120, FBHE 100 and return channel 102.

There is normally at least one superheater 14 located in the furnace 12, preferably on top of the furnace 12. Superheater 14 inlet 143 is preferably from steam drum 200 or from another superheater and the outlet 144 is to high pressure turbine.

In the method for determining a local temperature anomaly in a fluidized bed of a combustion boiler system 10 that comprises a furnace 12 having a boiler grid 250 that is equipped with at least three temperature sensors $20_i$ that preferably are located above the grid 250, the temperature sensors $20_i$ together defining a measurement grid where each temperature sensor $20_i$ represents a measurement point $P_i$, i = 1, ... , n:

- bed temperatures $T_{Mi}$, i = 1, ..., N are measured at the measurement points $P_i$, i = 1, ..., N;

- bed temperatures for the measurement points $P_i$, i = 1, ..., n are computed using at least one numerical bed temperature model, to obtain computed bed temperatures $T_{Ci}$; i = 1, ..., n under normal operation conditions of the combustion boiler system 10;

- the measured bed temperatures $T_{Mi}$ are compared with the computed bed temperatures $T_{Ci}$ for at least some of the measurement points $P_i$, i = 1, ..., n, and if an anomaly threshold is exceeded (for example $\Delta T = T_{Mi} - T_{Ci}$ is computed for all i, and if $\Delta T > \Delta T_{limit}$), determining that local temperature anomaly is present.

The computed bed temperatures $T_{Ci}$; i = 1, ..., N for the measurement points $P_i$, i = 1, ..., N are preferably obtained in the following way:

- a numerical model f between boiler operation data, namely at least primary air flow x1, fuel moisture x2, main steam flow x3, flue gas oxygen x4 and bed pressure x5 and the measured bed temperatures $T_{Mi}$; i = 1, ..., N at each measurement point ($P_i$, i = 1, ..., N, is prepared and calibrated, i.e. f(x1, x2, c3, x4, x5) = $T_{mi}$;

- current operation data of the boiler, including the measured bed temperature $T_{Mi}$; i = 1, ..., N at each measurement point Pi, i = 1, ..., N and at least primary air flow x1, fuel moisture x2, main steam flow x3, flue gas oxygen x4 and bed pressure x5, is monitored;

- for at least one measurement point $P_j$, j is some 1, ..., n, the numerical model is used to compute a computed temperature $T_{Cj}$, using current operation data and measured bed temperatures of at least two other measurement points;

- comparing the computed bed temperature $T_{ci}$ and the measured bed temperature $T_{Mi}$ against an anomaly criterion and determining that local temperature anomaly is present if the anomaly criteria is fulfilled.

The calibration may be performed in a delayed manner using historical data that is preferably at least M days old, where M is at least 3, preferably M is at least 7, more preferably M is at least 14.

The calibration may not be performed for a predefined time upon detecting a local temperature anomaly. In particular, the calibration may not be performed for a predefined time upon detecting a local temperature anomaly that fulfills a given threshold.

In the method for calibrating a numerical model of a fluidized bed of a combustion boiler system 10 which comprises a furnace 12 having a boiler grid 250 that is equipped with at least three temperature sensors $20_i$ that together define a measurement grid where each temperature sensor represents a measurement point $P_i$, i = 1, ..., N, and wherein the combustion boiler system 10 has been configured to produce measured bed temperatures $T_{Mi}$ at each of the measurement points $P_i$, i = 1, ..., N;

- current operation data of the boiler, including the measured bed temperature $T_{Mi}$; i = 1, ..., N at each measurement point Pi, i = 1, ..., n and at least primary air flow x1, fuel moisture x2, main steam flow x3, flue gas oxygen x4 and bed pressure x5, is monitored and collected to historical data;
- a numerical model f between boiler operation data, namely at least primary air flow x1, fuel moisture x2, main steam flow x3, flue gas oxygen x4 and bed pressure x5 and the measured bed temperatures $T_{Mi}$; i = 1, ..., N at each measurement point $P_i$, i = 1, ..., n is fitted using at least one numerical fitting method, preferably a numerical regression method, advantageously least squares fitting.

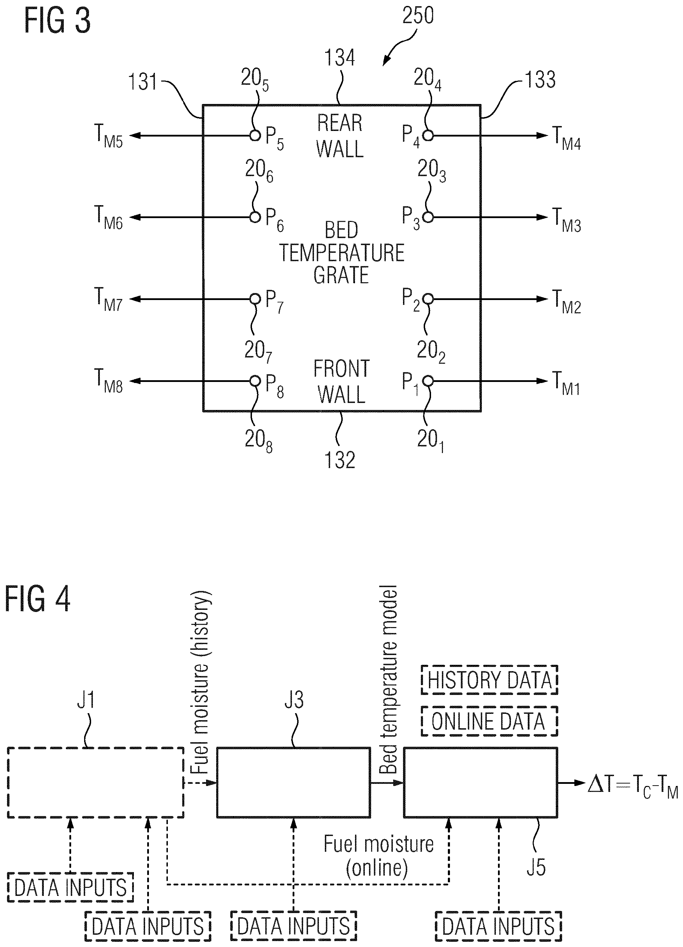

FIG 3 shows an example where the boiler grid 250 comprises eight temperature sensors 20 (thus N = 5). Basically, any number (though at least three) of temperature sensors 20 can be used.

The calibration is preferably repeated at predefined intervals, such as, periodically.

The calibration may be prevented upon detecting a local temperature anomaly.

According to the invention, in the method for estimating bed sintering risk of fluidized bed combustion boiler system (10) that comprises furnace (12) having a boiler grid (250) that is equipped with at least three temperature sensors ($20_i$) that together define a measurement grid where each temperature sensor represents a measurement point $P_i$, i = 1, ..., n :

- current operation data of the boiler, namely the measured bed temperature $T_{Mi}$; i = 1, ..., N, is measured at each measurement point $P_i$, i = 1, ..., n;
- based on the current operation data of the boiler,

    i) an average of the measured bed temperatures is computed;
    ii) standard deviation of measured bed temperature is computed;
    iii) a difference between measured bed maximum temperature and measured bed minimum temperature is computed;
    iv) spread $x_{spread, i} = x_i - \overline{x}_{\sim xi}$, is computed for the measured bed temperatures;

- using the computation results from i), ii), iii) and iv), preparing a bed sintering index.

According to an embodiment of the invention, in computation of spread i=1:N where N is the total number of bed temperature measurements, $x_i$ is an individual bed temperature measurement, and $\overline{x}_{\sim xi}$ is the average of all bed temperature measurements other than $x_i$.

Preferably, in the method also
v) computed bed temperatures $T_{Ci}$; l = 1, ..., n for same measurement points are computed, and residuals between the measured bed temperatures $T_{Mi}$; i = 1, ..., n and the computed bed temperatures are computed. The results from step v) are advantageously also used in the preparing of the bed sintering index.

In the method of controlling a fluidized bed boiler system 10,

local bed temperature anomalies and/or a bed sintering index is/are monitored; and

upon detecting a local bed temperature anomaly and/or bed sintering index exceeding a predefined criterion, automatically adjusting combustion boiler system 10 operation and/or indicating the boiler operator that a local bed temperature anomaly and/or a bed sintering condition is detected.

The automatic adjustment of boiler operation may include at least one of the following: a) increasing or decreasing primary and/or secondary air feed 151, 152, b) increasing or decreasing fuel feed 20, c) increasing or decreasing bed material feed and/or bed material removal and/or d) adjusting (preferably increasing) recirculation gas flow and/or e) restricting the boiler load temporarily.

The automatic adjustment or so-called remedial actions may include at least one of the following:

- change fuel mix
- trigger air pulse through primary air nozzles
- introducing feed additives such as clay which may be hydrous clay (e.g. kaolin), or increasing the amount of feed additives.

The local bed temperature anomalies and/or the monitoring sintering index is/are preferably monitored using a numerical model. Preferably, delayed calibration of the numerical model is used to reduce or avoid the effect of recent bed conditions in the calibration data.

The combustion boiler system 10 is configured to carry out the method according to the inventive method

FIG 4 illustrates the possible use of the method in a fluidized bed combustion system 10, more particularly, in DCS 301 and/or EDGE server 303, or in process intelligence system 305.

As data inputs (step J1), fuel moisture is provided to the method. This can be measured from the fuel or result from flue gas analysis, or entered manually.

In step J3, bed temperature is modelled.

In step J5, bed diagnostics is performed. As the result, residuals $\Delta T = T_C - T_M$ are obtained.

FIG 5 illustrates possible inputs to the bed diagnostics step J5. As possible inputs, primary air flow, secondary air flow, flue gas oxygen, flue gas $H_2O$, bed pressure are provided. They may be measured during the operation of the combustion boiler, preferably by the DCS 301 or EDGE server 303.

The remedial actions can be taken automatically (preferably by the DCS 301, EDGE server 303 or process intelligence system 305), or the boiler operator may take the actions manually.

FIG 6 illustrates the principle of delayed calibration.

The present inventors analyzed real boiler operation data that was collected during operation of a combustion boiler system 10 until the shutdown of the combustion boiler system 10 because of bed sintering. The present inventors are able to demonstrate (cf. FIG 7) that with their method, local bed temperature anomalies can be detected and that local bed temperature anomalies tend to act as precursors for bed sintering. With the present inventors' method, local bed temperature anomalies and, according to the invention, sintering conditions can be observed early enough within an action window that is suitably long and sufficiently much in advance before the actual problem. In the example of FIG 7, the action window was ca. 45 - 25 h before the combustion boiler system 10 had to be shut down because of a bed sintering problem.

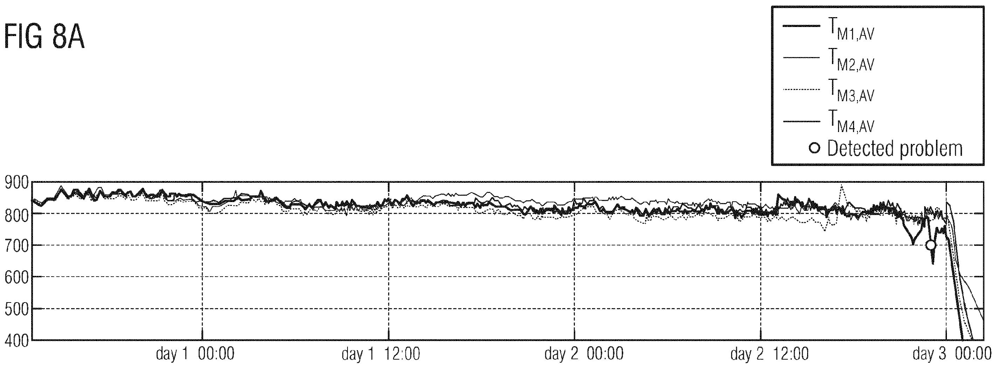

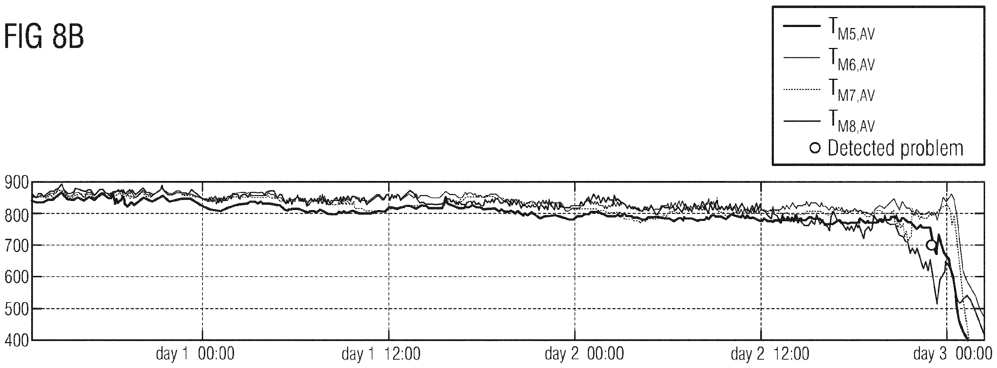

FIG 8A and 8B show the respective temperature sensor measurement data of temperature sensors $20_1$ to $20_8$ that resulted in the curve shown in FIG 7. Thus at least 8 temperature sensors 20 are sufficiently many to reliably detect a sintering problem early enough to enable a long enough action window for combustion boiler system 10 automatic control or manual control by the boiler operator, to prevent the shut down of the combustion boiler system 10.

It is obvious to the skilled person that, along with the technical progress, the basic idea of the invention can be implemented in many ways. The invention and its embodiments are thus not limited to the examples and samples described above but they may vary within the scope of the appended patent claims.

**List of used reference numerals:**

| | |
|---|---|
| 10 | combustion boiler system |
| 12 | furnace |
| 13 | tube wall |

| | |
|---|---|
| 14 | particle separator |
| 15 | crossover duct |
| 16 | back pass |
| 18 | flue gas duct |
| 19 | stack |
| $20_j$ | temperature sensor (i = 1, 2, 3, ..., 8) |
| $21_i$ | heat exchanger (j = 1, 2, 3, ..., k) |
| 22 | fuel feed |
| 100 | fluidized bed heat exchanger (FBHE) |
| 102 | return channel |
| 103 | vortex finder |
| 104 | FBHE inlet |
| 105 | FBHE outlet |
| 120 | loop seal |
| 131 | side wall |
| 132 | front wall |
| 133 | side wall |
| 134 | rear wall |
| 143 | superheater inlet |
| 144 | superheater outlet |
| 151 | primary fluidizing gas feed |
| 152 | secondary fluidizing gas feed |
| 153 | fluidizing gas supply |
| 180 | flue gas recirculation |
| 200 | steam drum |
| 203 | superheater |
| 250 | grid |
| 300 | internet |
| 301 | distributed control system (DCS) |
| 302 | display / monitor |
| 303 | EDGE server |
| 304 | local storage |
| 305 | process intelligence system |
| 306 | computation cloud |
| 308 | gateway |
| 370 | combustion boiler network |
| 380 | field bus |

**Claims**

1. A method for estimating risk of fluidized bed combustion boiler bed sintering, **wherein:**

   - the combustion boiler system (10) comprises furnace (12) having a boiler grid (250) that is equipped with at least three temperature sensors ($20_i$) that together define a measurement grid where each temperature sensor represents a measurement point ($P_i$, i = 1, ..., n)
   - current operation data of the boiler, namely the measured bed temperature ($T_{Mi}$; i = 1, ..., N), is measured at each measurement point ($P_i$, i = 1, ..., n);

   the method **characterised in that**

   - based on the current operation data of the boiler,

      i) an average of the measured bed temperatures is computed;
      ii) standard deviation of measured bed temperature is computed;
      iii) a difference between measured bed maximum temperature and measured bed minimum temperature is computed;
      iv) spread ($x_{spread,\ i} = x_i - \overline{x}_{\sim xi}$) is computed for the measured bed temperatures;

- using the computation results from i), ii), iii) and iv), preparing a bed sintering index.

2. The method according to claim 1, **wherein** in the method, further,
   v) computed bed temperatures ($T_{Ci}$; l = 1, ..., n) for same measurement points are computed, and residuals between the measured bed temperatures ($T_{Mi}$; i = 1, ..., n) and the computed bed temperatures are computed; and wherein results from step v) are also used in the preparing of the bed sintering index.

3. The method according to claim 2, **wherein:** the computed bed temperatures ($T_{Ci}$; l = 1, ..., n) are obtained such that

   - bed temperatures for the measurement points ($P_i$, i = 1, ..., n) are computed using at least one numerical bed temperature model between boiler operation data and the measured bed temperatures, to obtain computed bed temperatures ($T_{Ci}$; i = 1, ..., n) under normal operation conditions of the combustion boiler system (10).

4. The method according to anyone of the claims to 1 to 3, **wherein:**
   upon detecting a bed sintering index exceeding a predefined criterion, automatically adjusting combustion boiler system (10) operation and/or indicating the boiler operator that a bed sintering condition is detected.

5. The method according to claim 4, **wherein:** the automatic adjusting of boiler operation includes at least one of the following: a) increasing or decreasing combustion air feed (151, 152), b) increasing or decreasing fuel feed (20), c) increasing or decreasing bed material feed and/or bed material removal, d) adjusting recirculation gas flow, e) restricting the boiler load temporarily.

6. The method according to claim 4 or 5, **wherein:** monitoring sintering index is monitored using a numerical model, and wherein a delayed calibration of the numerical model used to reduce or avoid the effect of recent bed conditions in the calibration data.

7. The method according to claim 6, **wherein:** the delayed calibration is performed using following steps,
   wherein the combustion boiler system (10) has been configured to produce measured temperatures (TMi) at each of the measurement points (Pi, i = 1, ..., N);

   - current operation data of the boiler, including the measured temperature (TMi; i = 1, ..., N) at each measurement point (Pi, i = 1, ..., n) and at least primary air flow (x1), fuel moisture (x2), main steam flow (x3), flue gas oxygen (x4) and bed pressure (x5), is monitored and collected to historical data;
   - a numerical model (f) between boiler operation data, namely at least primary air flow (x1), fuel moisture (x2), main steam flow (x3), flue gas oxygen (x4) and bed pressure (x5) and the measured bed temperatures (TMi; i = 1, ..., N ) at each measurement point (Pi, i = 1, ..., n) is fitted using at least one numerical fitting method, preferably a numerical regression method, advantageously least squares fitting.

8. The method according to claim 7, **wherein:** the calibration is repeated at predefined intervals.

9. The method according to claim 7 or 8, **wherein:** the calibration is prevented upon detecting a local temperature anomaly.

10. A combustion boiler system (10) configured to carry out the method according to any one of the preceding claims.

**Patentansprüche**

1. Verfahren zum Schätzen der Gefahr einer Wirbelschichtfeuerungskessel-Bettsinterung, wobei:

   - die Feuerungskesselanlage (10) einen Ofen (12) umfasst, der einen Kesselrost (250) aufweist, der mit mindestens drei Temperatursensoren ($20_i$) ausgestattet ist, die zusammen ein Messraster definieren, in dem jeder Temperatursensor einen Messpunkt ($P_i$, i = 1, ..., n) darstellt,
   - aktuelle Betriebsdaten des Kessels, namentlich die gemessene Bett-Temperatur ($T_{Mi}$; i = 1, ..., N), an jedem Messpunkt ($P_i$, i = 1, ..., n) gemessen werden,

   das Verfahren **dadurch gekennzeichnet ist, dass**

- auf Grundlage der aktuellen Betriebsdaten des Kessels,

    i) ein Durchschnitt der gemessenen Bett-Temperaturen berechnet wird,
    ii) eine Standardabweichung der gemessenen Bett-Temperatur berechnet wird,
    iii) eine Differenz zwischen einer gemessenen Bett-Maximaltemperatur und einer gemessenen Bett-Minimaltemperatur berechnet wird,
    iv) eine Spreizung ($x_{spread,i} = x_i - \overline{x}_{\sim xi}$) für die gemessenen Bett-Temperaturen berechnet wird,

- unter Verwendung der Berechnungsergebnisse aus i), ii), iii) und iv) ein Bettsinterungsindex erstellt wird.

2. Verfahren nach Anspruch 1, wobei in dem Verfahren, ferner,
v) berechnete Bett-Temperaturen ($T_{Ci}$; I = 1, ..., n) für gleiche Messpunkte berechnet werden und Reste zwischen den gemessenen Bett-Temperaturen ($T_{Mi}$; i = 1, ..., n) und den berechneten Bett-Temperaturen berechnet werden und wobei die Ergebnisse aus Schritt v) ebenfalls bei der Erstellung des Bettsinterungsindex verwendet werden.

3. Verfahren nach Anspruch 2, wobei: die berechneten Bett-Temperaturen ($T_{Ci}$; I = 1, ..., n) derart erhalten werden, dass

- Bett-Temperaturen für die Messpunkte ($P_i$, i = 1, ..., n) unter Verwendung mindestens eines numerischen Bett-Temperaturmodells zwischen Kesselbetriebsdaten und den gemessenen Bett-Temperaturen berechnet werden, um berechnete Bett-Temperaturen ($T_{Ci}$; i = 1, ..., n) unter normalen Betriebsbedingungen der Feuerungskesselanlage (10) zu erhalten.

4. Verfahren nach einem der Ansprüche 1 bis 3, wobei:
auf ein Erkennen eines Bettsinterungsindex hin, der ein vordefiniertes Kriterium überschreitet, automatisch der Betrieb der Feuerungskesselanlage (10) angepasst wird und/oder dem Kesselbediener angezeigt wird, dass eine Bettsinterungsbedingung erkannt wird.

5. Verfahren nach Anspruch 4, wobei: das automatische Anpassen des Kesselbetriebs mindestens eines von Folgendem einschließt: a) Steigern oder Vermindern einer Verbrennungsluftzufuhr (151, 152), b) Steigern oder Vermindern einer Brennstoffzufuhr (20), c) Steigern oder Vermindern einer Bettmaterialzufuhr und/oder einer Bettmaterialentnahme, d) Anpassen eines Rückführungsgasstroms, e) zeitweiliges Beschränken der Kessellast.

6. Verfahren nach Anspruch 4 oder 5, wobei: das Überwachen des Sinterungsindex unter Verwendung eines numerischen Modells überwacht wird und wobei eine verzögerte Kalibrierung des numerischen Modells verwendet wird, um die Auswirkung von jüngsten Bettbedingungen bei den Kalibrierungsdaten zu vermeiden.

7. Verfahren nach Anspruch 6, wobei: die verzögerte Kalibrierung unter Verwendung der folgenden Schritte durchgeführt wird:
wobei die Feuerungskesselanlage (10) dafür konfiguriert worden ist, gemessene Temperaturen ($T_{Mi}$) an jedem von den Messpunkten ($P_i$, i = 1, ..., N) zu erzeugen,

- aktuelle Betriebsdaten des Kessels, welche die gemessene Temperatur ($T_{Mi}$; i = 1, ..., N) an jedem Messpunkt ($P_i$, i = 1, ..., n) und zumindest einen Primärluftstrom (x1), eine Brennstoff-Feuchtigkeit (x2), einen Hauptdampfstrom (x3), einen Rauchgas-Sauerstoff (x4) und einen Bettdruck (x5) einschließen, werden überwacht und zu Vergangenheitsdaten gesammelt,
- ein numerisches Modell (f) zwischen Kesselbetriebsdaten, namentlich zumindest dem Primärluftstrom (x1), der Brennstoff-Feuchtigkeit (x2), dem Hauptdampfstrom (x3), dem Rauchgas-Sauerstoff (x4) und dem Bettdruck (x5), und den gemessenen Bett-Temperaturen ($T_{Mi}$; i = 1, ..., N) an jedem Messpunkt ($P_i$, i = 1, ..., n) wird unter Verwendung mindestens eines numerischen Anpassungsverfahrens, vorzugsweise eines numerischen Regressionsverfahrens, vorteilhafterweise der Anpassung der kleinsten Quadrate, angepasst.

8. Verfahren nach Anspruch 7, wobei die Kalibrierung in vordefinierten Abständen wiederholt wird.

9. Verfahren nach Anspruch 7 oder 8, wobei die Kalibrierung auf das Erkennen einer örtlichen Temperaturanomalie hin verhindert wird.

10. Feuerungskesselanlage (10), die dafür konfiguriert ist, das Verfahren nach einem der vorhergehenden Ansprüche auszuführen.

**Revendications**

1. Procédé d'estimation du risque de frittage de lit de chaudière à combustion à lit fluidisé, dans lequel :

   - le système de chaudière à combustion (10) comprend un foyer (12) comportant une grille de chaudière (250) équipée d'au moins trois capteurs de température ($20_i$) définissant conjointement une grille de mesure où chaque capteur de température représente un point de mesure ($P_i$, i = 1, ..., n)
   - des données de fonctionnement actuelles de la chaudière, notamment la température de lit mesurée ($T_{Mi}$ ; i = 1, ..., N), sont mesurées à chaque point de mesure ($P_i$, i = 1, ..., n) ;

   le procédé étant **caractérisé en ce que**

   - sur la base des données de fonctionnement actuelles de la chaudière,

      i) une moyenne de la température de lit mesurée est calculée ;
      ii) un écart standard de la température de lit mesurée est calculé ;
      iii) une différence entre la température maximale de lit mesurée et la température minimale de lit mesurée est calculée ;
      iv) une répartition ($x_{spread,\ i} = x_i - \bar{x}_{\sim xi}$) est calculée pour les températures de lit mesurées ;

   - un indice de frittage de lit est préparé à l'aide des résultats de calcul de i), ii), iii) et iv).

2. Procédé selon la revendication 1, dans lequel, dans le procédé, en outre,
   v) des températures de lit calculées ($T_{Ci}$ ; l = 1, ..., n) pour des mêmes point de mesure sont calculées, et des résidus entre les températures de lit mesurées ($T_{Mi}$ ; i = 1, ..., N) et les températures de lit calculées sont calculés ; et dans lequel des résultats de l'étape v) sont également utilisés dans la préparation de l'indice de frittage de lit.

3. Procédé selon la revendication 2, dans lequel : les températures de lit calculées ($T_{Ci}$ ; l = 1, ..., n) sont obtenues de telle façon que

   - des températures de lit pour les points de mesure ($P_i$, i = 1, ..., n) sont calculées à l'aide d'au moins un modèle de températures de lit numérique entre des données de fonctionnement de chaudière et les températures de lit mesurées, pour l'obtention de températures de lit calculées ($T_{Ci}$ ; i = 1, ..., n) dans des conditions de fonctionnement normales du système de chaudière à combustion (10).

4. Procédé selon l'une quelconque des revendications 1 à 3, dans lequel :
   lors de la détection d'un indice de frittage de lit dépassant un critère prédéfini, le fonctionnement du système de chaudière à combustion (10) est réglé automatiquement et/ou il est indiqué à l'opérateur de la chaudière qu'une condition de frittage de lit est détectée.

5. Procédé selon la revendication 4, dans lequel : le réglage automatique du fonctionnement de la chaudière inclut au moins l'un parmi : a) l'augmentation ou la réduction de l'alimentation en air de combustion (151, 152), b) l'augmentation ou la réduction de l'alimentation en combustible (20), c) l'augmentation ou la réduction de l'alimentation en matériau de lit et/ou l'élimination de matériau de lit, d) le réglage du flux de gaz de recirculation, e) la restriction temporaire de la charge de la chaudière.

6. Procédé selon la revendication 4 ou 5, dans lequel : la surveillance de l'indice de frittage est surveillée à l'aide d'un modèle numérique, et dans lequel un étalonnage différé du modèle numérique est utilisé pour réduire ou éviter l'effet de conditions de lit récentes dans les données d'étalonnage.

7. Procédé selon la revendication 6, dans lequel:

   l'étalonnage différé est effectué à l'aide des étapes suivantes,
   dans lequel le système de chaudière à combustion (10) a été configuré pour produire des températures mesurées (TMi) à chacun des points de mesure ($P_i$, i = 1, ..., N) ;

      - des données de fonctionnement actuelles de la chaudière, incluant la température de lit mesurée ($T_{Mi}$ ; i = 1, ..., N) à chaque point de mesure ($P_i$, i = 1, ..., n) et au moins le flux d'air primaire (x1), l'humidité du combustible (x2), le flux de vapeur principal (x3), l'oxygène des effluents gazeux (x4) et la pression de lit (x5), sont surveillées et enregistrées dans les données historiques ;

- un modèle numérique (f) entre des données de fonctionnement de la chaudière, notamment au moins le flux d'air primaire (x1), l'humidité du combustible (x2), le flux de vapeur principal (x3), l'oxygène des effluents gazeux (x4) et la pression de lit (x5) et les températures de lit mesurées (TMi ; i = 1, ..., N) à chaque point de mesure (Pi, i = 1, ..., n), est ajusté à l'aide d'au moins un procédé d'ajustement numérique, de préférence un procédé de régression numérique, avantageusement un ajustement aux moindres carrés.

8. Procédé selon la revendication 7, dans lequel: l'étalonnage est répété à des intervalles prédéfinis.

9. Procédé selon la revendication 7 ou 8, dans lequel: l'étalonnage est empêché lors de la détection d'une anomalie de température locale.

10. Système de chaudière à combustion (10) configuré pour mettre en œuvre le procédé selon l'une quelconque des revendications précédentes.

FIG 1

# FIG 2

FIG 3

131    $20_5$    134    $20_4$    133

$T_{M5}$ ← $P_5$    REAR WALL    $P_4$ → $T_{M4}$

$20_6$    $20_3$

$T_{M6}$ ← $P_6$    BED TEMPERATURE GRATE    $P_3$ → $T_{M3}$

$T_{M7}$ ← $P_7$    $P_2$ → $T_{M2}$

$20_7$    $20_2$

$T_{M8}$ ← $P_8$    FRONT WALL    $P_1$ → $T_{M1}$

$20_8$    $20_1$

132

250

FIG 4

J1    Fuel moisture (history)    J3    Bed temperature model    HISTORY DATA

ONLINE DATA

$\Delta T = T_C - T_M$

J5

Fuel moisture (online)

DATA INPUTS

DATA INPUTS    DATA INPUTS    DATA INPUTS

# FIG 5

| INPUTS | MODEL | OUTPUT |
|---|---|---|

INPUTS
Primary air flow
Secondary air flow
FG oxygen
FG H2O
Bed pressure
...

MODEL

OUTPUT
Bed temperature
(modeled)
...

$T_C$

$\Delta T = T_M - T_C$

REMEDIAL ACTIONS

MEASUREMENT
Bed temperature
...

$T_M$

# FIG 6

Time of prediction

2 months

TRAINING DATA

2 weeks

NOT USED

# FIG 7

$T_M$
$T_C$
○ Problem

BED TEMPERATURE [°C]

900

800

700

600

500

Action window

Shutdown started

-350    -300    -250    -200    -150    -100    -50    0

TIME [h] before problem

EP 4 399 449 B1

FIG 8A

# FIG 8B

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2009105013 A2